# FASCICULE DE BREVET EUROPEEN

(11) **EP 1 744 373 B1**
(45) Date de publication et mention de la délivrance du brevet: **05.12.2018**
(21) Numéro de dépôt: 05366005.6
(22) Date de dépôt: 13.07.2005
(51) Int. Cl.: H01L 33/48, H01L 33/62, H01L 23/32

(54) **Dispositif de maintien et de connexion de composants optoélectroniques comme les LEDs du type PLCC2 et PLCC4**
Halterung und Verbindungssockel für optoelektronische Bauteile wie LEDs vom Typ PLCC2 oder PLCC4
Holding and connection device for optoelectronic components like LEDs of the PLCC2 or PLCC4 type

(43) Date de publication de la demande: 17.01.2007
(73) Titulaire: CML Innovative Technologies, 25000 Besancon (FR)
(72) Inventeur: Anderlini, Daniel, 25530 Chevigney les Vercel (FR)
(74) Mandataire: Rhein, Alain

(56) Documents cités:
- DE-A1- 10 053 573
- DE-A1- 10 134 381
- FR-A- 2 870 083
- US-A- 4 303 297
- US-A- 5 706 177
- US-A1- 2005 030 754

## Description

La présente invention concerne un dispositif de maintien et de connexion de diodes électroluminescentes (LEDs) du type PLCC2 et PLCC4.

Habituellement, les composants optoélectroniques, tels que les diodes électroluminescentes, sont fixés sur les circuits imprimés au moyen d'une soudure. Cependant, comme les circuits imprimés destinés à la fixation de diodes électroluminescentes sont rigides et plats, il devient compliqué et coûteux de réaliser des dispositifs d'éclairage ayant une forme spécifique, telle qu'une forme bombée.

Par ailleurs, lors du montage de ces diodes électroluminescentes sur les circuits imprimés, il est nécessaire d'effectuer plusieurs opérations, à savoir la dépose d'adhésif sur le circuit, la dépose de la diode électroluminescente, la dépose d'étain sur le dispositif qui est ensuite passé en four de soudure. Un contrôle des soudures est ensuite réalisé en fin de montage.

Ces diverses contraintes augmentent les coûts de production des dispositifs utilisant les composants optoélectroniques, tels que les diodes électroluminescentes, dans la mesure où leur montage est long et parfois compliqué en cas de forme non plane.

L'invention se propose de remédier à ces divers inconvénients en proposant un dispositif permettant d'assurer à la fois le maintien et la connexion électrique des composants optoélectroniques, tels que les diodes électroluminescentes, tout en assurant une flexibilité au niveau des formes et une simplification du processus de montage.

A cet effet, la présente invention a pour objet un dispositif de maintien et de connexion des diodes électroluminescentes du type PLCC2 et PLCC4, caractérisé en ce que ledit dispositif est constitué d'un corps sur lequel est disposée une grappe métallique selon la revendication 1.

Les diodes électroluminescentes, désignées sous l'abréviation LEDs, sont du type PLCC2 et PLCC4, les LEDs sont des composant optoélectroniques destinées aux montages en surface.

On comprendra mieux l'invention en référence aux dessins annexés sur lesquels :

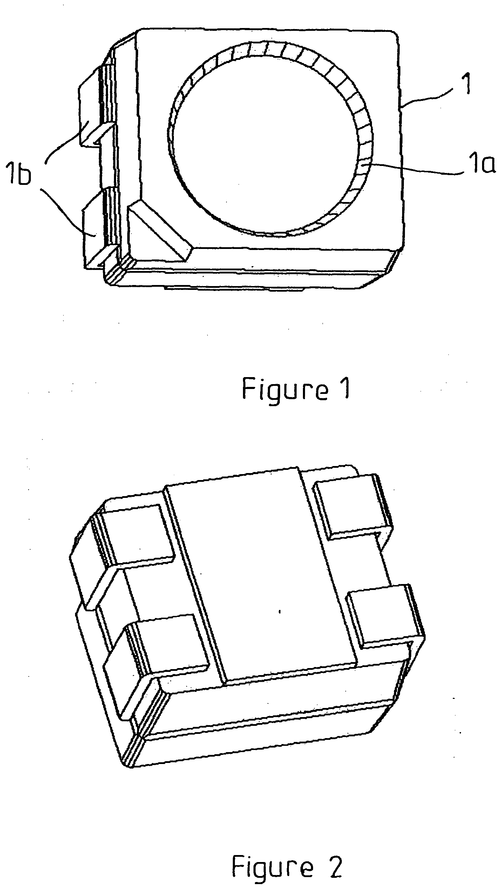

- la figure 1 est une représentation schématique d'une LED vue de dessus,
- la figure 2 est une représentation d'une LED vue de dessous,

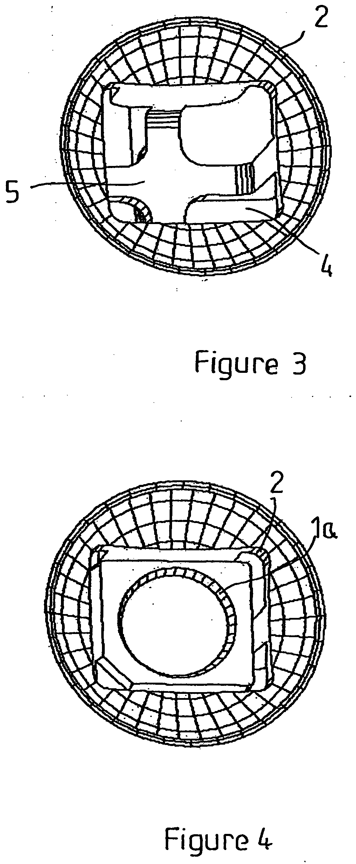

- la figure 3 est une représentation du corps,
- la figure 4 est une représentation du corps après insertion de la LED,

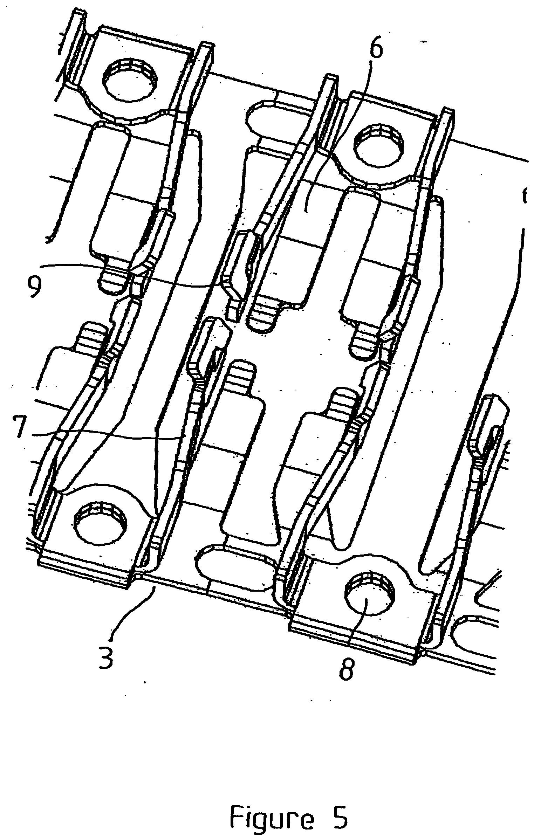

- la figure 5 est une représentation de la grappe métallique,

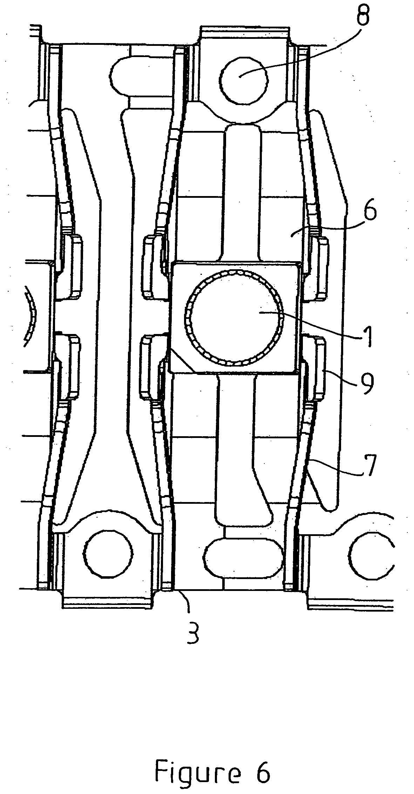

- la figure 6 est une représentation du dessus de la grappe métallique lors de la fixation de la LED,

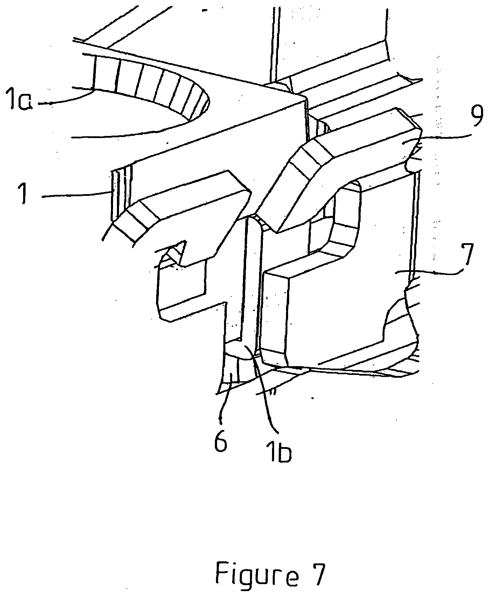

- la figure 7 est une représentation latérale de la grappe métallique lors de la fixation de la LED.

Les LEDs 1 sont composées d'une zone éclairante 1a et d'électrodes 1b assurant la connexion électrique.

Le dispositif selon l'invention est constitué principalement d'un corps 2 en matière plastique sur lequel est fixée une grappe métallique 3. Une LED 1 s'insère dans la grappe métallique 3.

La grappe métallique est constituée d'un ensemble de contacts réalisant des pistes électriques, cet ensemble étant découpé et plié selon les formes que l'on souhaite réaliser.

Cet ensemble monobloc est ensuite assemblé et séparé par une opération appelée déshuntage. Lors de cette opération, des ponts, appelés également shunts, reliant les différentes pistes électriques sont coupés, permettant ainsi d'obtenir un circuit électrique opérationnel.

Par sa composition plastique, le corps 2 pourra être de forme plane ou bombée, ou de toute autre forme, selon l'esthétique de l'éclaireur souhaitée.

Ce corps 2 est d'une forme telle qu'il permet l'insertion de la LED 1 tout en la bloquant. En effet, il est muni à la fois d'ouvertures 4 destinées au positionnement des LEDs 1 à assembler ainsi que de butées 5 qui vont arrêter la LED 1 lors de son insertion dans le corps 2.

La grappe métallique 3 qui se fixe sur le corps 2 comporte un bras de contact 6 ainsi qu'un bras destiné au positionnement et au maintien 7 des LEDs. Elle est munie de trous 8 permettant sa fixation au corps 2.

Le bras de contact 6 de la grappe métallique 3 permet d'établir le contact électrique avec les électrodes 1b situées sous la LED 1. Ce bras de contact 6 est constitué d'une matière élastique, qui lui permet de travailler en déformation et lui assure un bon contact électrique sur les électrodes 1b.

Le bras de positionnement 7 de la grappe métallique 3 assure quant à lui un contact électrique sur les électrodes 1b des LEDs. Ce contact est réalisé sur le côté des électrodes 1b. Par ailleurs, le bras de positionnement 7 assure le positionnement de la LED 1 dans son logement.

Sur sa partie supérieure, ce bras 7 est muni d'un ergot 9 qui se positionne sur la partie supérieure de l'électrode 1b de la LED 1, assurant ainsi le maintien de cette dernière dans son logement ainsi que son appui sur le bras de contact 6.

Le produit selon l'invention permet d'assurer le contact électrique en au moins deux points sur chaque électrode de la LED grâce au bras de contact et grâce à l'ergot situé sur le bras de maintien, agissant ensemble pour maintenir le contact.

Par ailleurs, chacun des bras de la grappe métallique assure un rôle thermique dans la mesure où ils permettent la dissipation de la chaleur émise par la LED par l'intermédiaire des électrodes.

Par ailleurs, afin de réaliser le circuit électrique recherché, la grappe métallique est munie de ponts ou de shunts. Ceux-ci seront coupés lors de l'assemblage de la grappe métallique sur le corps plastique.

La grappe métallique peut être munie d'une ou de plusieurs LEDs. Elle peut avoir différentes formes s'ajustant aux formes du corps plastique permettant la réalisation de circuits électriques en trois dimensions.

## Revendications

1. Dispositif de maintien et de connexion pour des diodes électroluminescentes LEDs du type PLCC2 et PLCC4, dispositif constitué d'un corps (2) en matière plastique sur lequel est disposé une grappe métallique (3), **caractérisé en ce que** la grappe métallique (3) est constituée d'un élément de contact (6) en relation avec des électrodes (1b) situées sous une desdites LEDs (1), et d'éléments (7) de positionnement et maintien en relation avec les cotés des électrodes (1b) d'une desdites LEDs chacun desdits éléments (7) comportant un ergot (9) sur sa partie supérieure appuyant sur la partie supérieure de l'électrode (1b).

2. Dispositif de maintien et de connexion selon la revendication 1, **caractérisé en ce que** le corps (2) est muni d'ouvertures (4) et de butées (5).

## Patentansprüche

1. Vorrichtung zum Halten und zum Verbinden für elektrolumineszente LED-Dioden vom Typ PLCC2 und PLCC4, wobei die Vorrichtung aus einem Körper (2) aus Plastikmaterial besteht, auf dem ein Metallteil (3) angeordnet ist, **dadurch gekennzeichnet, dass** der Metallteil (3) aus einem Kontaktelement (6) mit Bezug auf Elektroden (1b) besteht, die sich unter den LEDs (1) befinden, und Elementen (7) zum Positionieren und Halten mit Bezug auf die Seiten der Elektroden (1b) einer der LEDs, wobei jedes der Elemente (7) einen Zapfen (9) auf seinem oberen Teil umfasst, der auf den oberen Teil der Elektrode (1b) drückt.

2. Vorrichtung zum Halten und Verbinden nach Anspruch 1, **dadurch gekennzeichnet, dass** der Körper (2) mit Öffnungen (4) und Anschlägen (5) ausgestattet ist.

## Claims

1. A holding and connection device for light-emitting diodes LEDs of type PLCC2 and PLCC4, device made up of a plastic body (2) on which a metal cluster (3) is arranged, **characterized in that** the metal cluster (3) is made up of a contact element (6) in relation with electrodes (1b) located below one of said LEDs (1), and elements (7) for positioning and holding in relation with the sides of the electrodes (1b) of one of said LEDs, each of said elements (7) including a lug (9) on its upper part bearing on the upper part of the electrode (1b).

2. The holding and connection device according to claim 1, **characterized in that** the body (2) is provided with openings (4) and stops (5).
